# FASCICULE DE BREVET EUROPEEN

(11) **EP 4 264 679 B1**
(45) Date de publication et mention de la délivrance du brevet: **05.02.2025**
(21) Numéro de dépôt: 21847997.0
(22) Date de dépôt: 09.12.2021
(51) Int. Cl.: H01L 31/18, C23C 14/50

(54) **PROCÉDÉ DE FABRICATION D'AU MOINS UNE CELLULE PHOTOVOLTAÏQUE EN UTILISANT UNE PLAQUE EN APPUI SUR AU MOINS UN FIL**
HERSTELLUNGSVERFAHREN VON MINDESTENS EINER PHOTOVOLTAÏSCHEN ZELLE MIT EINEM VON MINDESTENS EINEM DRAHT UNTERSTÜTZTEN WAFER
METHOD FOR FABRICATING AT LEAST ONE PHOTOVOLTAIC CELL USING A WAFER SUPPORTED BY AT LEAST ONE WIRE

(30) Priorité: 16.12.2020 FR 2013368
(43) Date de publication de la demande: 25.10.2023
(73) Titulaire: Commissariat à l'Energie Atomique et aux Energies Alternatives, 75015 Paris (FR)
(72) Inventeur: COUSTIER, Fabrice, 38054 Grenoble Cedex 09 (FR); JAY, Frédéric, 38054 Grenoble Cedex 09 (FR); TOMASSINI, Mathieu, 38054 Grenoble Cedex 09 (FR)
(74) Mandataire: Germain Maureau
(86) Numéro de dépôt international: PCT/FR2021/052255
(87) Numéro de publication internationale: WO 2022/129739

(56) Documents cités:
- CN-U- 213 583 724
- JP-A- 2013 184 717
- KR-A- 20040 078 795
- US-A1- 2012 108 002
- US-A1- 2017 117 423

## Description

### Domaine technique de l'invention

Le domaine technique de l'invention concerne un procédé de fabrication d'au moins une cellule photovoltaïque. Dans le cadre de ce procédé de fabrication, il est cherché à former un premier matériau conducteur sur une première face d'une plaque et un deuxième matériau conducteur sur une deuxième face de la plaque opposée à la première face de la plaque. Notamment, la cellule photovoltaïque peut être à base de silicium cristallin et par exemple de type à hétérojonction. Par exemple, la cellule photovoltaïque peut comporter une hétérojonction silicium amorphe (a-Si) - silicium cristallin (c-Si).

### État de la technique

Il est connu, notamment dans le domaine de la fabrication de cellules photovoltaïques, de déposer un même type matériau sur des première et deuxième faces opposées d'une plaque au cours d'un passage de la plaque dans un équipement de dépôt dudit matériau, comme illustré par exemple dans le document US2012108002 A1.

Ce matériau peut être un oxyde transparent conducteur. Pour réaliser ce dépôt, il peut être utilisé un dispositif de support, aussi appelé plateau de transport, destiné à traverser l'équipement de dépôt. Le plateau de transport est configuré pour supporter et maintenir des plaques. À cet effet, le plateau de transport comporte des trous débouchants usinés de sorte à former chacun un logement, aussi appelé « pocket » en langue anglaise, pour une plaque correspondante. Par exemple, chaque trou débouchant comporte, pour former le logement correspondant, un épaulement notamment délimité par une variation de la section du trou débouchant dans l'épaisseur du plateau de transport. L'épaulement est alors destiné à former une surface d'appui pour une plaque correspondante. Chaque épaulement est tel que la surface d'appui va venir en contact avec la périphérie de la première face de la plaque correspondante, ainsi la surface d'appui adopte la forme d'une boucle fermée. Ainsi, les plaques peuvent être positionnées chacune dans un des logements de sorte que, pour chaque plaque :
- une portion périphérique de la première face de ladite plaque est en contact avec la surface d'appui du trou correspondant, assurant ainsi le support de ladite plaque, et
- une autre portion de la première face, entourée par la portion périphérique, de ladite plaque est accessible dans le trou,
- la deuxième face de ladite plaque est entièrement accessible dans le trou.

Lorsque les plaques sont positionnées dans les trous et supportées par le plateau de transport, le plateau de transport peut traverser l'équipement de dépôt de sorte à permettre le dépôt du matériau à l'aide de deux cibles, respectivement placées en haut et en bas de l'équipement de dépôt. Les cibles peuvent comporter l'oxyde transparent conducteur comme par exemple un oxyde d'indium-étain. Grâce à ces cibles, il est possible de réaliser le dépôt de l'oxyde transparent conducteur par pulvérisation cathodique qui s'effectue dans toutes les directions et vient donc recouvrir toutes les surfaces non protégées des plaques. Ainsi, pour chaque plaque, le dépôt est donc total sur la deuxième face de ladite plaque et est en partie masqué sur la première face de ladite plaque par la surface d'appui sur laquelle ladite plaque repose.

Pour chaque trou, l'épaulement va, d'une part, permettre d'assurer le support de la plaque correspondante et, d'autre part, servir de masque afin d'assurer une discontinuité électrique entre le matériau déposé sur la première face de la plaque correspondante et le matériau déposé sur la deuxième face de la plaque correspondante, ceci permettant par exemple la formation sur la plaque correspondante de deux électrodes distinctes et opposées d'une cellule photovoltaïque correspondante.

Un tel plateau de transport présente les inconvénients suivants :
- les plaques, en fonction de leur taille et de leur épaisseur, peuvent se courber lorsqu'elles sont placées chacune dans un logement correspondant,
- le masquage partiel des premières faces des plaques par les surfaces d'appui lors de la fabrication des cellules photovoltaïques induit un rendement qui n'est pas optimal lors du fonctionnement de ces cellules photovoltaïques,
- il est limité à un format de plaques, il faut donc des plateaux de transport spécifiques de manière à ce que les surfaces d'appui, assurant le support mécanique des plaques, permettent également, dans le cadre de la fabrication de cellules photovoltaïques un masquage correct du dépôt de l'oxyde transparent conducteur sur toute la périphérie de la première face de chacune des plaques,
- en fonction des dimensions de plaques, elles peuvent se courber lors de leur support par le plateau de transport ce qui peut porter préjudice à la qualité du dépôt de l'oxyde transparent conducteur.

Par exemple, en prenant une largeur de la surface d'appui de 1,2 mm, il est possible que le plateau de transport puisse supporter des plaques de dimensions variables en prenant en compte, par exemple, une variabilité de dimension de plus ou moins 0,25 mm entre les plaques. Ainsi, une telle largeur de la surface d'appui permet de garantir un support adapté de la plaque correspondante et l'obtention d'une bonne isolation électrique entre le matériau déposé sur la première face de la plaque correspondante et le matériau déposé sur la deuxième face de la plaque correspondante. Cependant, en prenant comme exemple une cellule photovoltaïque formée à partir d'une plaque carrée ou pseudo-carrée, par exemple de 156 mm de côté, cela induit la présence, à la première face, d'une surface inactive correspondant à une fraction de la surface totale de la première face de la plaque après dépôt de l'oxyde transparent conducteur à cause de l'utilisation de la surface d'appui. Ainsi, si la cellule photovoltaïque présente un rendement théorique, le rendement effectif de la cellule photovoltaïque est strictement inférieur au rendement théorique à cause cette surface inactive non recouverte d'oxyde transparent conducteur.

Ainsi, il existe un besoin d'améliorer le support d'une plaque lors de la fabrication d'une cellule photovoltaïque par exemple pour pallier à au moins un des inconvénients listés ci-dessus.

### Objet de l'invention

L'invention a pour but d'améliorer la manière dont est supportée au moins une plaque au cours d'un procédé de fabrication d'au moins une cellule photovoltaïque en utilisant la plaque. Ceci permettant, par exemple, d'améliorer la formation d'au moins un matériau conducteur sur la plaque.

À cet effet, l'invention est relative à un procédé de fabrication d'au moins une cellule photovoltaïque, le procédé de fabrication comportant les étapes suivantes :
a) prévoir au moins une plaque, ladite plaque comportant une première face et une deuxième face opposée à la première face,
b) prévoir un dispositif de support,
c) positionner la plaque en plaçant la première face de la plaque en contact avec le dispositif de support,
d₁) former un premier matériau conducteur sur la première face de la plaque alors que la plaque est supportée par le dispositif de support,
d₂) former un deuxième matériau conducteur sur la deuxième face de la plaque alors que la plaque est supportée par le dispositif de support,
le procédé de fabrication étant tel que :
   - au moins l'un des premier et deuxième matériaux conducteurs est transparent,
   - le dispositif de support comporte au moins un fil, et
   - durant tout ou partie de l'étape d₁), la première face de la plaque est en appui sur le fil.

L'utilisation du fil, ou le cas échéant de plusieurs fils, permet d'améliorer le support de la plaque au cours de l'étape d₁) et de l'étape d₂) afin notamment d'améliorer la formation du premier matériau conducteur et la formation du deuxième matériau conducteur. Selon une réalisation, cette amélioration du support permet par exemple d'éviter ou de limiter la courbure de la plaque à l'aide du ou des fils et par exemple tout en limitant le masquage de la première face de la plaque ; ceci permettant d'améliorer l'homogénéité des premier et deuxième matériaux conducteurs formés sur la plaque. Selon une réalisation, cette amélioration du support peut permettre, par exemple à l'aide de plusieurs fils, d'assurer un support de la plaque adapté pour tendre à maximiser la surface de la première face de la plaque sur laquelle le premier matériau conducteur est formé en vue d'améliorer le rendement de la cellule photovoltaïque.

Le procédé de fabrication peut comporter en outre une ou plusieurs des caractéristiques suivantes :
- le dispositif de support comporte un emplacement pour la plaque, l'emplacement comportant une portée d'appui, et, à l'issue de l'étape c) et durant toute l'étape d₁), la première face de la plaque est en appui sur la portée d'appui et sur le fil ;
- à l'issue de l'étape c), la première face de la plaque est en appui sur des fils du dispositif de support ;
- le procédé de fabrication est tel que : le dispositif de support comporte un premier ensemble de fils et un deuxième ensemble de fils ; l'étape d₁) comporte une première période et une deuxième période pendant lesquelles le premier matériau conducteur est formé sur la première face de la plaque ; pendant la première période, la première face de la plaque est en appui sur les fils du premier ensemble de fils tandis que les fils du deuxième ensemble de fils sont à distance de la plaque ; pendant la deuxième période, la plaque repose, par l'intermédiaire du premier matériau conducteur formé sur la première face de la plaque lors de la première période, sur les fils du deuxième ensemble de fils tandis que les fils du premier ensemble de fils sont à distance de la plaque ;

- l'étape d₁) comporte, alors que les fils supportent la plaque, un déplacement relatif entre la plaque et les fils ;
- le déplacement relatif est exécuté par utilisation de vibrations mécaniques ou acoustiques ;
- le procédé de fabrication est tel que : le fil du dispositif de support ou chaque fil du dispositif de support comporte une âme et une pluralité de grains, les grains de la pluralité de grains étant fixés sur l'âme ; et à l'issue de l'étape c) et tout au long de l'étape d₁), la première face de la plaque est en appui seulement sur des grains ;
- le procédé de fabrication est tel que : à l'issue de l'étape c), les fils forment un masque agencé contre la première face de la plaque ; ledit masque empêche, lorsque l'étape d₁) est exécutée, la formation du premier matériau conducteur sur une portion de la première face de la plaque, ladite portion s'étendant à la périphérie de la première face de la plaque ; et il résulte de l'exécution de étape d₁) et de l'étape d₂), la présence d'une première couche réalisée dans le premier matériau conducteur et agencée sur la première face de la plaque, et la présence d'une deuxième couche réalisée dans le deuxième matériau conducteur et en contact avec la deuxième face de la plaque, les première et deuxième couches étant disjointes ;
- avant l'étape c), la position des fils est ajustée en fonction des dimensions de la plaque ;
- le premier matériau conducteur et le deuxième matériau conducteur sont chacun choisis parmi : un oxyde transparent conducteur et un matériau métallique ;
- le procédé de fabrication comporte une étape d) de formation d'une matière à la surface de la plaque, cette étape d) étant exécutée par la mise en oeuvre, par exemple simultanée, des étapes d₁) et d₂), le premier matériau conducteur et le deuxième matériau conducteur correspondant à un même oxyde transparent conducteur ;
- il résulte des étapes d₁) et d₂) la formation d'une matière à la surface de la plaque, et le procédé de fabrication comporte une étape e) consistant à délimiter, dans la matière, une première couche en contact avec la première face de la plaque et une deuxième couche en contact avec la deuxième face de la plaque de telle sorte que la première couche est disjointe de la deuxième couche, l'étape e) comportant une étape de retrait d'une portion de la matière ;
- l'étape de retrait est exécutée par une meule ou un laser ;
- le retrait de la portion de la matière est réalisé sur un bord latéral de la plaque, le bord latéral reliant les première et deuxième faces de la plaque ;
- le procédé de fabrication est tel que : l'étape c) positionne un élément de masquage appartenant au dispositif de support sur une zone de découpe formée par une partie de la surface de la première face, l'élément de masquage empêchant la formation du premier matériau conducteur sur la zone de découpe tout au long de l'étape d₁) ; et il comporte une étape de séparation de la plaque en au moins deux parties, l'étape de séparation étant exécutée, après l'étape d₁), par découpe au travers de la zone de découpe ;
- l'étape a) consiste à prévoir plusieurs plaques et pour chaque plaque : l'étape c) est exécutée de sorte à positionner ladite plaque, l'étape d₁) est exécutée sorte que le premier matériau conducteur est déposé sur la première face de ladite plaque, l'étape d₂) est exécutée de sorte que le deuxième matériau conducteur est déposé sur la deuxième face de ladite plaque.

L'invention est aussi relative à un dispositif de support destiné à supporter au moins une plaque lors de la formation d'un premier matériau conducteur et d'un deuxième matériau conducteur sur la plaque. Le dispositif de support comporte au moins un fil, le fil étant agencé de sorte à participer au support de la plaque.

Le dispositif de support peut comporter en outre une ou plusieurs des caractéristiques suivantes :
- le dispositif de support comporte au moins un emplacement pour la plaque, l'emplacement comportant une portée d'appui, la portée d'appui et le fil étant agencés pour participer chacun et de manière simultanée au support de la plaque ;
- le dispositif de support comporte plusieurs fils ;
- le dispositif de support est tel que : les fils sont répartis en un premier ensemble de fils et en un deuxième ensemble de fils ; il comporte un mécanisme de positionnement des fils configuré pour varier entre une première configuration et une deuxième configuration ; dans la première configuration, les fils du premier ensemble de fils sont positionnés dans une zone de support ; dans la première configuration, les fils du deuxième ensemble de fils sont à distance de la zone de support ; dans la deuxième configuration, les fils du deuxième ensemble de fils sont positionnés dans la zone de support ; et dans la deuxième configuration, les fils du premier ensemble de fils sont à distance de la zone de support ;
- le dispositif de support comporte un générateur de vibrations mécaniques ou acoustiques.

D'autres avantages et caractéristiques pourront ressortir de la description détaillée qui suit.

### Description sommaire des dessins

L'invention sera mieux comprise à la lecture de la description détaillée qui suit, donnée uniquement à titre d'exemple non limitatif et faite en se référant aux dessins annexés et listés ci-dessous.
La figure 1 représente schématiquement une vue en coupe d'un exemple de cellule photovoltaïque fabriquée par un procédé de fabrication selon un mode de réalisation de la présente invention.
La figure 2 représente schématiquement une vue en perspective d'un exemple de plaque utilisée au cours du procédé de fabrication.
La figure 3 représente schématiquement une vue de dessus d'un exemple de dispositif de support utilisé au cours du procédé de fabrication.
La figure 4 représente, selon un mode de réalisation du procédé de fabrication et de manière schématique, une étape consistant à former un matériau conducteur sur une ou des plaques par pulvérisation cathodique.
La figure 5 illustre schématiquement, selon une réalisation particulière de l'invention, une vue de dessus du dispositif de support supportant une plaque.
La figure 6 est une vue schématique selon la coupe A-A de la figure 5.
La figure 7 illustre schématiquement, selon une autre réalisation particulière de l'invention, une vue de dessus du dispositif de support supportant une plaque.
La figure 8 est une vue schématique selon la coupe B-B de la figure 7.
La figure 9 illustre schématiquement un perfectionnement du dispositif de support de la figure 7, ce perfectionnement permettant notamment de supporter une plaque de grande taille et/ou d'éviter la courbure de la plaque.
La figure 10 est une vue schématique selon la coupe C-C de la figure 9.
La figure 11 représente, selon une vue de dessus, une réalisation particulière et schématique du dispositif de support permettant de supporter plusieurs plaques à la fois.
La figure 12 représente, selon une vue de dessus et schématique, une autre réalisation particulière du dispositif de support permettant de supporter plusieurs plaques à la fois.
La figure 13 représente schématiquement, selon une vue en coupe, le résultat de la formation de premier et deuxième matériaux conducteurs à la surface de la plaque alors que la plaque est supportée par deux fils.
La figure 14 illustre schématiquement, selon une vue de dessus, une réalisation particulière du dispositif de support supportant une plaque, ce dispositif de support comportant des fils déplaçables.
La figure 15 est une vue schématique selon la coupe D-D de la figure 14 lorsqu'un mécanisme de positionnement adopte une première configuration.
La figure 16 est une vue schématique selon la coupe D-D de la figure 14 lorsque le mécanisme de positionnement adopte une deuxième configuration.
La figure 17 représente schématiquement, selon une vue en coupe, le résultat de la formation de premier et deuxième matériaux conducteurs à la surface de la plaque alors que la plaque est supportée par un fil à grains.
La figure 18 représente schématiquement une réalisation selon laquelle la plaque est supportée par un masque à fils.
La figure 19 est une vue détaillée d'une partie de la figure 18.
La figure 20 représente schématiquement une autre réalisation selon laquelle la plaque est supportée par un masque à fils.
La figure 21 illustre schématiquement, selon une vue en coupe, le résultat d'étapes consistant à former des premier et deuxième matériaux conducteurs sur la plaque lorsque la plaque est supportée selon la réalisation de la figure 7.
La figure 22 illustre schématiquement, selon une vue en coupe, le résultat de d'une formation de premier et deuxième matériaux conducteurs sur la plaque lorsque la plaque est supportée par le dispositif de support selon les figures 14 à 16.
La figure 23 illustre schématiquement, selon une vue en coupe partielle, une étape de retrait, à l'aide d'une meule, de matière formée sur la plaque.
La figure 24 illustre schématiquement, selon une vue en coupe partielle, une étape de retrait, à l'aide d'un laser, de matière formée sur la plaque
La figure 25 illustre schématiquement, selon une vue en coupe une étape de séparation d'une plaque en deux parties pour former deux cellules photovoltaïques.
La figure 26 illustre schématiquement, selon une vue en coupe, le dispositif de support, selon une réalisation particulière, supportant une plaque.

Sur ces figures, les mêmes références sont utilisées pour désigner les mêmes éléments. De plus, les différents éléments ne sont pas représentés à l'échelle de manière à privilégier la clarté des figures.

### Description détaillée

Dans la présente description, par « compris entre deux valeurs », il est entendu que les bornes formées par ces deux valeurs sont incluses dans la plage correspondante.

Par « à base de » en parlant d'un objet à base d'un matériau, il est entendu dans la présente description que le matériau est majoritaire dans la composition de l'objet.

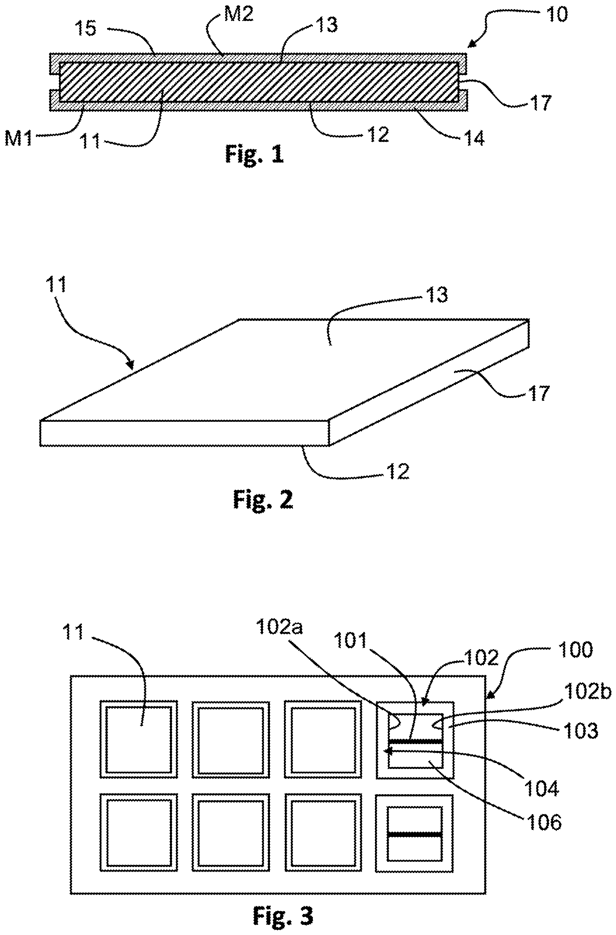

La présente invention s'inscrit dans le contexte de la fabrication d'au moins une cellule 10 photovoltaïque en utilisant au moins une plaque 11. Notamment, tout ce qui s'applique à la plaque 11 peut s'appliquer aux plaques 11 lorsqu'il y en a plusieurs. Un exemple de la cellule 10 photovoltaïque dont une partie est formée par la plaque 11 est illustré en figure 1. Ainsi, la cellule 10 photovoltaïque peut comporter la plaque 11. La plaque 11, comme illustrée en exemple en figures 1 et 2, comporte une première face 12 et une deuxième face 13 opposée à la première face 12. De préférence, la cellule 10 photovoltaïque est telle qu'il est agencé sur les première et deuxième faces 12, 13 respectivement un premier matériau M1 conducteur et un deuxième matériau M2 conducteur, par exemple obtenus chacun par dépôt sur la plaque 11. Notamment, le premier matériau M1 conducteur est agencé de sorte à ce qu'une première couche 14 réalisée en ce premier matériau M1 conducteur est en contact avec la première face 12. Notamment, le deuxième matériau M2 conducteur est agencé de sorte qu'une deuxième couche 15 réalisée en ce deuxième matériau M2 conducteur est en contact avec la deuxième face 13. De préférence, la deuxième face 13 est recouverte par la deuxième couche 15. De préférence, la première face 12 est recouverte par la première couche 14 ou est couverte partiellement par la première couche 14. Alternativement à cet exemple de cellule 10 photovoltaïque, la plaque 11 peut être découpée, après avoir subi des étapes technologiques par exemple de microélectronique et comportant notamment la formation du premier matériau M1 conducteur et du deuxième matériau M2 conducteur, pour former plusieurs cellules 10 photovoltaïques.

Par « conducteur » dans la présente description, il est entendu électriquement conducteur.

Par « fabrication d'au moins une cellule 10 photovoltaïque », il est entendu que le procédé de fabrication peut être mis en oeuvre de sorte à fabriquer plusieurs cellules 10 photovoltaïques à la fois. Tout ce qui s'applique à une plaque 11 pour former une ou plusieurs cellules 10 photovoltaïques peut s'appliquer à des plaques 11 formant chacune une partie d'une des cellules 10 photovoltaïques, ou à des plaques 11 chacune à découper pour former plusieurs cellules 10 photovoltaïques.

La plaque 11 peut être une tranche ou « wafer » en langue anglaise qui aura été fonctionnalisée par exemple de sorte à former une hétérojonction pour cellule(s) photovoltaïque(s). En ce sens, la plaque 11 peut être à base de silicium cristallin et en particulier être de type à hétérojonction, par exemple une hétérojonction silicium amorphe (a-Si) - silicium cristallin (c-Si).

Par exemple, la plaque 11 peut avoir été obtenue par des méthodes classiques de la microélectronique en partant d'un substrat de silicium cristallin dopé comportant des faces opposées. Sur l'une de ces faces opposées du substrat de silicium cristallin, une jonction p-n est formée ; et, sur l'autre de ces faces opposées du substrat de silicium cristallin, une jonction n-n ou p-p est formée suivant le dopage du silicium cristallin.

Le procédé de fabrication de ladite au moins une cellule 10 photovoltaïque comporte les étapes suivantes :
a) prévoir ladite au moins une plaque 11, formant par exemple une partie de la cellule 10 photovoltaïque à fabriquer, cette partie intégrant une hétérojonction,
b) prévoir un dispositif 100 de support aussi appelé plateau de transport, par exemple les figures 3 à 12, 14 à 16 et 18 montrent des exemples du dispositif 100 de support, le dispositif 100 de support étant configuré pour supporter la plaque 11,
c) positionner la plaque 11 en plaçant la première face 12 de la plaque 11 en contact avec le dispositif 100 de support d'où il résulte que la plaque 11 est supportée par le dispositif 100 de support,
d₁) former le premier matériau M1 conducteur, par exemple par dépôt, sur la première face 12 de la plaque 11 alors que la plaque 11 est supportée par le dispositif 100 de support,
d₂) former le deuxième matériau M2 conducteur, par exemple par dépôt, sur la deuxième face 13 de la plaque 11 alors que la plaque 11 est supportée par le dispositif 100 de support.

Bien entendu, les étapes d₁) et d₂) sont exécutées après l'étape c) et par exemple l'une après l'autre ou simultanément. Le dispositif 100 de support, prévu à l'étape a), comporte au moins un fil 101 (par exemple visible en figures 3, 6, 7, 8, 9, 10, 11, 12, 13, 17, 18, 19, 20). Durant tout ou partie (c'est-à-dire pendant au moins une partie) de l'étape d₁), la première face 12 de la plaque 11 est en appui sur le fil 101. Par ailleurs, durant tout ou partie de l'étape d₂), la première face 12 de la plaque 11 peut être en appui sur le fil 101. Le procédé de fabrication permet de mettre en oeuvre un support à l'aide du fil 101, ce qui présente l'avantage d'améliorer le support de la plaque 11 d'où il résulte une amélioration lors de la formation des premier et deuxième matériaux M1, M2 conducteurs respectivement sur les première et deuxième faces 12, 13.

Par « être en appui sur », il est entendu qu'un contact est établi entre un premier élément, comme la première face 12 de la plaque 11, et un deuxième élément, comme le ou les fils 101 sur lequel ou lesquels le premier élément est en appui. La force d'appui exercée par le premier élément sur le deuxième élément peut être résultante de la gravité.

Tout ce qui s'applique au fil 101 dans la présente description peut s'appliquer à chaque fil 101 lorsque le dispositif 100 de support en comporte plusieurs.

Le fil 101 peut être lisse et, par exemple, il ne comporte rien d'autre que le fil 101 qui peut alors être constitué d'un ou de plusieurs brins. Le fil 101 lisse est dépourvu des grains évoqués ci-après et ne présente notamment pas de déformation selon sa longueur. Le fil 101 peut dans ce cas présenter un diamètre compris entre 10 µm et 350 µm et préférablement compris entre 20 µm et 100 µm. Le fil 101 peut être métallique, par exemple en acier.

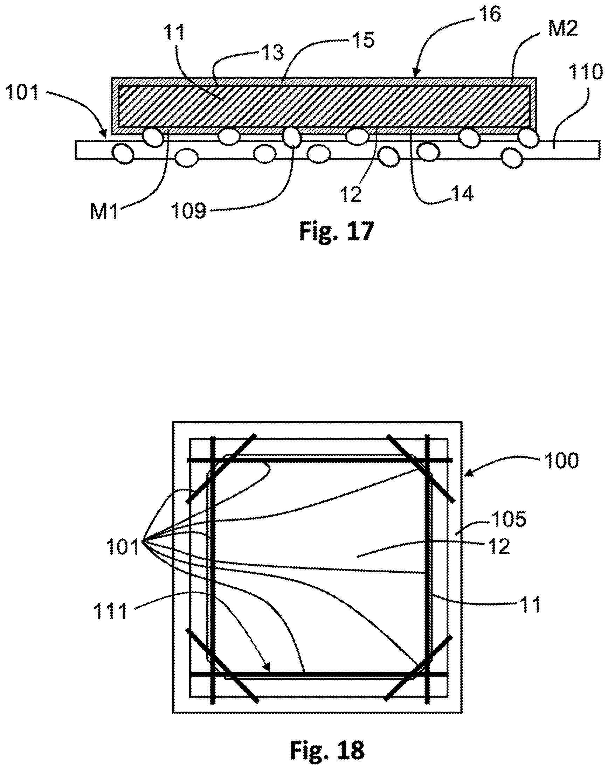

Le fil 101 peut comporter une âme 110, aussi appelée fil de support, et des grains 109 liés à cette âme 110 (voir par exemple figure 17). L'âme 110 peut dans ce cas présenter un diamètre compris entre 10 µm et 350 µm et préférablement compris entre 20 µm et 100 µm. Les grains 109 peuvent présenter une taille pouvant aller jusqu'à 100 µm et notamment la taille de chaque grain 109 peut être comprise entre 10 µm et 20 µm. L'âme 110 peut être constituée d'un ou de plusieurs brins. L'âme 110 peut être métallique, par exemple en acier. Un tel fil 101 peut être un fil diamanté.

L'étape d₁) et/ou l'étape d₂) peuvent être telles que les formations du premier matériau M1 conducteur et du deuxième matériau M2 conducteur sont réalisées par dépôt. Ainsi, l'étape d₁) peut consister à déposer le premier matériau M1 conducteur par exemple par dépôt physique en phase vapeur, aussi connu sous le sigle PVD correspondant à « physical vapor déposition » en langue anglaise ; il en va de même pour le deuxième matériau M2 qui peut être déposé par PVD (étape d₂)).

Notamment, la cellule 10 photovoltaïque comporte une face avant et une face arrière opposée à la face avant. La face avant de la cellule 10 photovoltaïque est par définition la face destinée à être orientée notamment pour recevoir le rayonnement incident à capter par la cellule 10 photovoltaïque. La face arrière est une face non directement éclairée par le rayonnement lumineux que la cellule 10 photovoltaïque doit capter.

Au moins l'un des premier et deuxième matériaux M1, M2 conducteurs est transparent. Cette transparence est notamment définie par rapport au rayonnement, notamment incident, à capter par la cellule 10 photovoltaïque pour générer une énergie électrique. Ce rayonnement est le rayonnement solaire. Notamment, la transparence est définie comme la capacité de laisser passer la gamme spectrale du rayonnement solaire utile pour le fonctionnement de la cellule 10 photovoltaïque.

Cette transparence dudit au moins un des premier et deuxième matériaux M1, M2 conducteurs, est dictée par le fait que l'une des première et deuxième faces 12, 13 de la plaque 11 sera considérée comme étant du côté (c'est-à-dire la plus proche en comparaison à l'autre des première et deuxième faces 12, 13) de la face avant de la cellule 10 photovoltaïque. La face avant de la cellule 10 photovoltaïque étant destinée à être orientée pour recevoir le rayonnement incident, il faut donc s'assurer que le matériau (M1 ou M2) formé du côté de cette face avant est transparent pour laisser passer le rayonnement.

La première face 12 de la plaque 11 est, de préférence celle qui sera du côté de la face arrière de la cellule 10 photovoltaïque (la deuxième face 13 est alors plus éloignée de la face arrière de la cellule 10 photovoltaïque que l'est la première face 12) et dans ce cas le premier matériau M1 conducteur peut être transparent ou non. En fait, le support préférentiel de la plaque 11 via la première face 12 qui sera du côté de la face arrière de la cellule 10 photovoltaïque est dicté par le fait que des endroits éventuellement non-recouverts de la première face 12 du fait du support de la plaque 11 seront réfléchissants au rayonnement à capter par la cellule 10 photovoltaïque notamment si ces endroits sont en silicium ou comportent du silicium : il vaut mieux que la face avant de la cellule 10 photovoltaïque ne présente pas de parties réfléchissantes au rayonnement à capter par la cellule 10 photovoltaïque.

Les premier et deuxième matériau M1, M2 sont conducteurs car ils sont notamment destinés chacun à former tout ou partie d'une électrode correspondante de la cellule 10 photovoltaïque.

Les premier et deuxième matériau M1, M2 conducteur peuvent être identiques ou différents, lorsqu'ils sont identiques ils peuvent être formés, par exemple en même temps ou non, par une étape d) formant une matière (constituant les premier et deuxième matériaux M1, M2) à la surface de la plaque 11. Ainsi, le procédé de fabrication peut comporter l'étape d) de formation de la matière à la surface de la plaque 11, cette étape d) étant exécutée par la mise en oeuvre, par exemple simultanée ou non, des étapes d₁) et d₂), le premier matériau M1 conducteur et le deuxième matériau M2 conducteur correspondant à un même oxyde transparent conducteur. Ceci permet par exemple de déposer les premier et deuxième matériaux M1, M2 conducteurs en utilisant le même dispositif 100 de support, et le cas échéant dans le même temps si les étapes d₁) et d₂) sont simultanées.

Tout en respectant bien entendu le fait que l'un des premier et deuxième matériaux M1, M2 conducteur est transparent, chacun des premier et deuxième matériaux M1, M2 conducteur peut être choisi parmi : un oxyde transparent conducteur aussi connu sous le sigle TCO pour « transparent conductive oxide » en langue anglaise et un matériau métallique, l'une des propriétés du matériau métallique est qu'il n'est pas transparent. Par exemple, le TCO peut être un oxyde d'indium-étain, aussi appelé oxyde d'indium dopé à l'étain, et connu sous le sigle ITO correspondant à « indium-tin oxide » en langue anglaise. Par exemple, le matériau métallique peut être de l'argent ou de l'aluminium. De tels matériaux sont tout particulièrement adaptés pour former les premier et deuxième matériaux M1, M2 conducteurs.

Par exemple, le TCO peut être utilisé dans le cadre de la réalisation d'une électrode transparente pour faire la liaison avec du silicium amorphe de la plaque 11 et une grille de métallisation de l'électrode transparente agencée du côté de la face avant de la cellule 10 photovoltaïque.

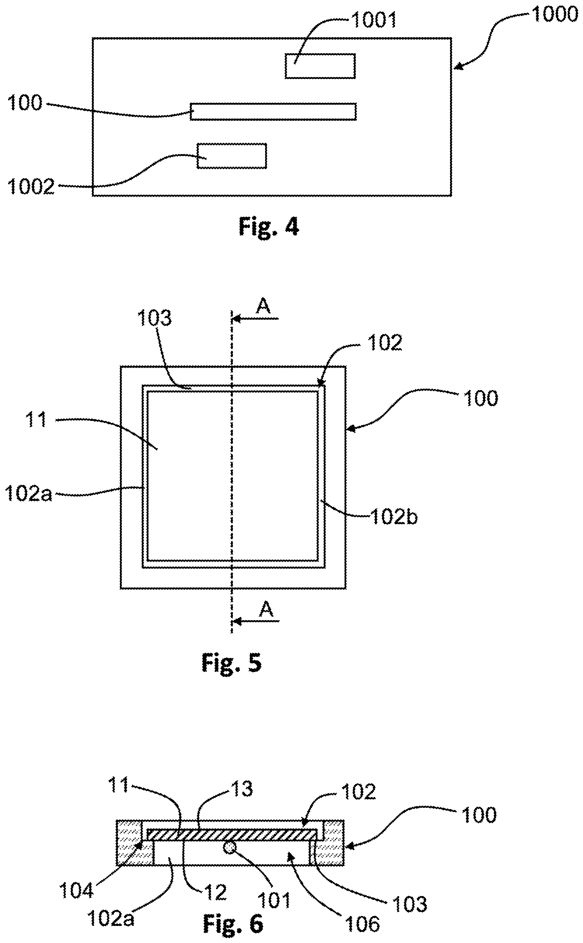

Par exemple, l'étape d₁) est mise en oeuvre par dépôt du premier matériau M1 conducteur et peut comporter une étape de passage du dispositif 100 de support, supportant la plaque 11 ou plusieurs plaques 11, par exemple comme représenté en figures 3, 5 à 12, 14 à 16 ou 18, dans un équipement 1000 de dépôt, aussi appelé enceinte de dépôt et dont un exemple particulier est représenté en figure 4. Par « passage du dispositif 100 de support dans l'équipement 1000 de dépôt », il est entendu que le dispositif 100 de support traverse l'équipement 1000 de dépôt. Il résulte qu'à l'issue de l'étape de passage, le premier matériau M1 conducteur a été déposé sur la ou les plaques 11.

Par exemple, l'étape d₂) est mise en oeuvre par dépôt du deuxième matériau M2 conducteur et peut comporter une étape de passage du dispositif 100 de support, supportant la plaque 11 ou plusieurs plaques 11, dans un équipement 1000 de dépôt (qui peut être identique ou distinct de celui utilisé pour le dépôt du premier matériau M1 conducteur). Il résulte qu'à l'issue de l'étape de passage, le deuxième matériau M2 conducteur a été déposé sur la ou les plaques 11.

Comme évoqué, les étapes d₁) et d₂) peuvent correspondre à une même étape d), notamment de dépôt, mise en oeuvre par une même étape de passage du dispositif 100 de support, supportant la plaque 11 ou plusieurs plaques 11 dans l'équipement 1000 de dépôt. Dans ce cas, le premier matériau M1 et le deuxième matériau M2 sont identiques.

L'équipement 1000 de dépôt est préférentiellement un équipement permettant de réaliser un dépôt physique en phase vapeur par pulvérisation d'au moins une cible. La ou les cibles 1001, 1002 peuvent être chacune, le cas échéant, en TCO comme l'ITO ou en un composé métallique comme l'argent ou l'aluminium en fonction du premier matériau M1 conducteur à déposer et/ou du deuxième matériau M2 conducteur à déposer. Par exemple pour mettre en oeuvre l'étape d), des cibles 1001, 1002 sont respectivement placées en haut et en bas de l'équipement 1000 mais pas en regard l'une de l'autre dans le référentiel de la figure 4, afin de réaliser un dépôt de matière dans toutes les directions pour recouvrir les surfaces non protégées de la ou les plaques 11 supportées par le dispositif 100 de support.

Bien qu'il ait été décrit ci-dessus un équipement 1000 de dépôt dit « à passage », les étapes d₁) et d₂) peuvent aussi être mises en oeuvre à l'aide d'un ou de plusieurs équipement permettant un dépôt dit « en stationnaire », c'est-à-dire sans nécessiter un passage du dispositif 100 de support au travers de l'équipement 1000 concerné.

Bien entendu, l'invention est aussi relative au dispositif 100 de support destiné à supporter ladite au moins une plaque 11 lors de la formation du premier matériau M1 conducteur et du deuxième matériau M2 conducteur sur la plaque 11. En particulier, le dispositif 100 de support est configuré pour supporter la plaque 11 notamment tout rendant accessible la deuxième face 13 et la première face 12 en vue d'y former les premier et deuxième matériaux M1, M2 conducteurs. Autrement dit, le dispositif 100 de support est configuré pour permettre de former les premier et deuxième matériaux M1, M2 conducteurs respectivement sur la première face 12 de la plaque 11 et sur la deuxième face 13 de la plaque 11 lorsqu'elle est supportée, notamment via sa première face 12, à l'aide du fil 101. Dès lors, le dispositif 100 de support comporte ledit au moins un fil 101, le fil 101 étant agencé de sorte à participer au support de la plaque 11, en particulier lorsque la première face 12 de la plaque 11 est en appui sur le fil 101. Un tel support présente l'avantage de limiter la zone de contact entre le fil 101 et la plaque 11 d'où il résulte par exemple un masquage provoqué par le fil 101 limité aux dimensions du fil 101 sur la deuxième face 12 de la plaque 11 lorsque cette deuxième face 12 est en appui sur le fil 101.

Selon une réalisation, par exemple telle qu'illustrée en figures 3, 5 et 6, le dispositif 100 de support comporte au moins un emplacement 102 pour la plaque 11. L'emplacement 102 comporte une portée 103 d'appui, la portée 103 d'appui et le fil 101 étant notamment agencés pour participer chacun et de manière simultanée au support de la plaque 11. Par exemple, l'emplacement 102 est un logement permettant de loger la plaque 11 ; ce logement peut être formé dans une ouverture 106 et être délimité par un épaulement 104. Ainsi, le fil 101 peut être agencé en travers de l'emplacement 102 et notamment de l'ouverture 106 de sorte à relier deux parties 102a, 102b opposées de l'emplacement 102 et en particulier de l'épaulement 104. Le fil 101 peut être agencé en travers de l'emplacement 102 en son centre, c'est-à-dire à équidistance entre deux portions opposées de la portée 103 d'appui. La combinaison d'une portée 103 d'appui et du fil 101 en vue de supporter la plaque 11 présente l'avantage de maintenir la rigidité de la plaque 11, notamment au cours de l'étape d₁) et au cours de l'étape d₂). Par ouverture 106, il est entendu que l'ouverture 106 traverse le dispositif 100 de support, cette ouverture 106 est donc débouchante et peut être considérée comme un trou débouchant. En particulier, en fonction de la taille et de la finesse de la plaque 11, un tel emplacement 102 permet, grâce à l'aide du fil 101, de limiter ou d'éviter la courbure de la plaque 11 lorsqu'elle est supportée par le dispositif 100 de support ; ceci se traduisant dans le cadre du procédé de fabrication par :
- l'obtention d'une meilleure homogénéité des premier et deuxième matériaux M1, M2 conducteurs formés/déposés sur la plaque 11 en terme d'épaisseur pour chacune des première et deuxième couches 14, 15, et en terme de propriétés électriques pour chacune des première et deuxième couches 14, 15,
- l'obtention d'une meilleure homogénéité en terme de propriétés optiques pour ledit au moins un des premier et deuxième matériaux M1, M2 conducteurs qui est transparent. Selon cette réalisation, à l'issue de l'étape c) et durant toute l'étape d₁), ainsi que notamment durant toute l'étape d₂), la plaque 11 (et plus précisément la première face 12 de la plaque 11) est préférentiellement en appui sur la portée 103 d'appui et sur le fil 101, ceci permettant de limiter ou d'éviter la courbure de la plaque 11 lors de l'exécution de l'étape d₁) et, le cas échéant, lors de l'exécution de l'étape d₂). En particulier, le dispositif 100 de support est ici configuré pour maintenir le fil 101 tendu, par exemple par fixation mécanique et en utilisant au moins un ressort pour assurer une tension prédéterminée du fil 101, assurant ainsi un support adapté de la plaque 11. Plusieurs fils 101, notamment maintenus tendus, peuvent être utilisés afin d'améliorer encore le support de la plaque 11 : dans ce cas, lorsque la plaque 11 est supportée par le dispositif 100 de support, elle est alors en appui sur ces fils 101, notamment tout au long de l'étape d₁) et de l'étape d₂) et à l'issue de l'étape c).

Bien entendu, le dispositif 100 de support peut comporter plusieurs emplacements 102 tels que décrit, comme par exemple visible en figure 3, afin de permettre de former les premier et deuxième matériaux M1, M2 conducteurs sur plusieurs plaques 11 à la fois.

Le dispositif 100 de support peut comporter plusieurs fils 101. Dans ce cas, à l'issue de l'étape c), la première face 12 de la plaque 11 est en appui sur des fils 101 du dispositif 100 de support, il en résulte notamment que la première face 12 de la plaque 11 est en appui sur des fils 101 durant tout ou partie de l'étape d₁) et notamment durant tout ou partie de l'étape d₂). Ceci présente l'avantage d'assurer un bon support de la plaque 11 tout en limitant globalement la surface masquée par ces fils 101 d'où il résulte une optimisation de la surface de la première face 12 de la plaque 11 couverte par le premier matériau M1 conducteur à l'issue de l'étape d₁). Un autre avantage d'utiliser des fils 101 est que la plaque 11 peut être supportée seulement par ces fils 101, d'où il résulte que le dispositif 100 de support peut recevoir différents formats de plaque : un même dispositif 100 de support peut être utilisé pour permettre la formation des premier et deuxième matériaux M1,M2 conducteurs sur des plaques 11 de dimensions différentes, que cela soit au cours du même procédé de fabrication ou lors de mises en oeuvres différentes du procédé de fabrication (lors d'une première mise en oeuvre le dispositif 100 de support peut être utilisé avec un premier format de plaque, puis lors d'une mise en oeuvre suivante le dispositif 100 de support peut être utilisé avec un deuxième format de plaque différent du premier format). De préférence, le dispositif 100 de support est configuré pour maintenir ces fils 101 tendus, par exemple à l'aide de moyens de serrage et éventuellement de ressorts, pour permettre un support adapté de la plaque 11.

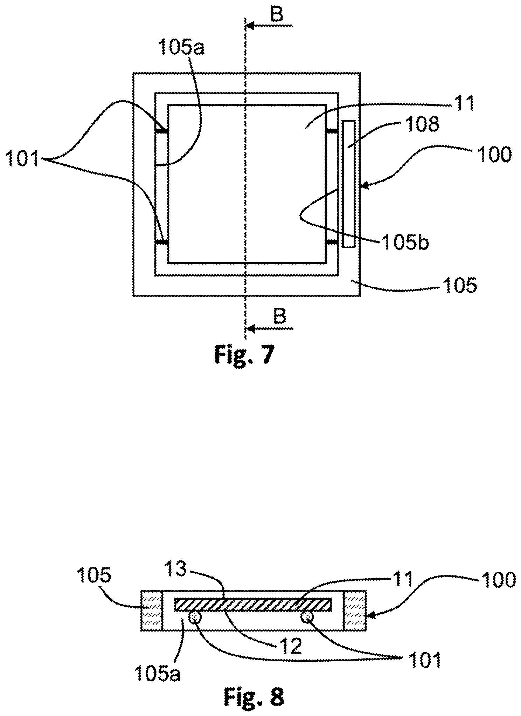

Selon une réalisation, comme illustré par exemple en figures 7 et 8, le dispositif 100 de support peut présenter deux fils 101 agencés pour supporter une même plaque 11. Dans cette réalisation, la plaque 11 est préférentiellement en contact seulement avec les fils 101 à l'issue de l'étape c) et en particulier durant toute l'étape d₁), ceci présentant l'avantage de limiter le masquage de la première face 12 lors de l'exécution de l'étape d₁). Dans ce cas, le dispositif 100 de support peut comporter un cadre 105, le cadre 105 comportant deux bords 105a, 105b opposés reliés par les fils 101 qui sont alors tendus entre ces deux bords 105a, 105b. Les fils 101 peuvent être attachés mécaniquement au cadre 105 par exemple par serrage de vis et être tendus par exemple en utilisant des ressorts.

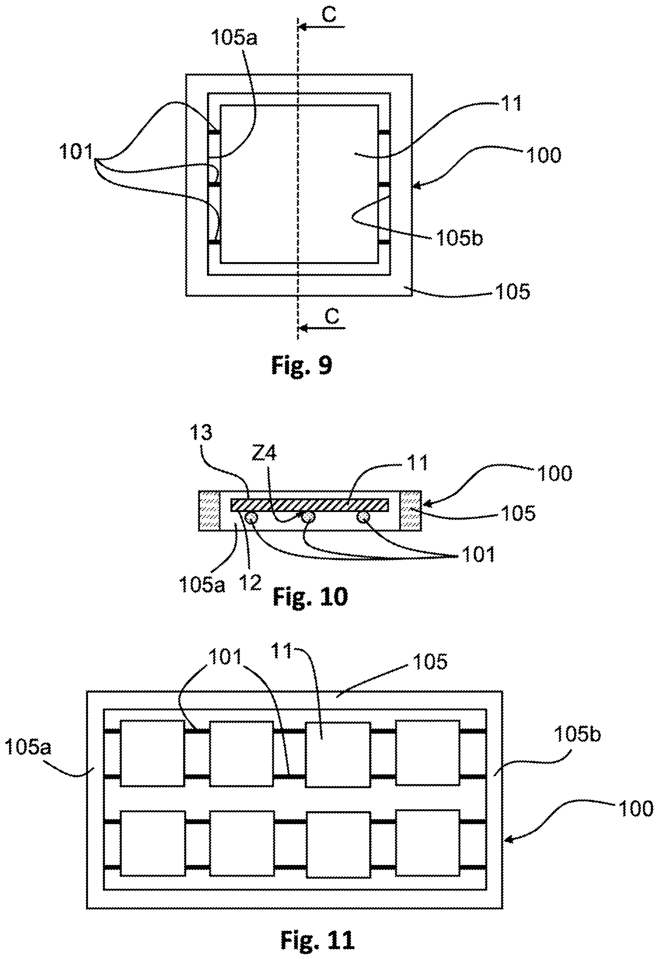

Selon un perfectionnement, par exemple tel que visible en figures 9 et 10, le dispositif 100 de support peut comporter au moins trois fils 101 agencés pour supporter une même plaque 11 ; ces trois fils 101 reliant par exemple les deux bords 105a, 105b opposés du cadre 105. Ceci présente l'avantage de maintenir la rigidité de la plaque 11, notamment lors de l'étape d₁) et, le cas échéant, lors de l'étape d₂). En particulier, en fonction de la taille et de la finesse de la plaque 11, ces trois fils 101 permettent de limiter ou d'éviter la courbure de la plaque 11 lorsqu'elle est supportée par le dispositif 100 de support, ceci se traduisant dans le cadre du procédé de fabrication par :
- l'obtention d'une meilleure homogénéité des premier et deuxième matériaux M1, M2 conducteurs formés/déposés sur la plaque 11 en terme d'épaisseur pour chacune des première et deuxième couches 14, 15, et en terme de propriétés électriques pour chacune des première et deuxième couches 14, 15,
- l'obtention d'une meilleure homogénéité en terme de propriétés optiques pour ledit au moins un des premier et deuxième matériaux M1, M2 conducteurs qui est transparent. Le nombre de fils 101 peut ici être adapté en fonction de la taille et de l'épaisseur de la plaque 11. Bien qu'en figures 9 et 10 il n'est représenté qu'une plaque 11, le dispositif 100 de support peut être adapté pour porter plusieurs plaques 11 en simultané, ces plaques 11 pouvant être supportées par les mêmes trois fils 11 ou chacune par un triplet de fils 101 qui lui est propre.

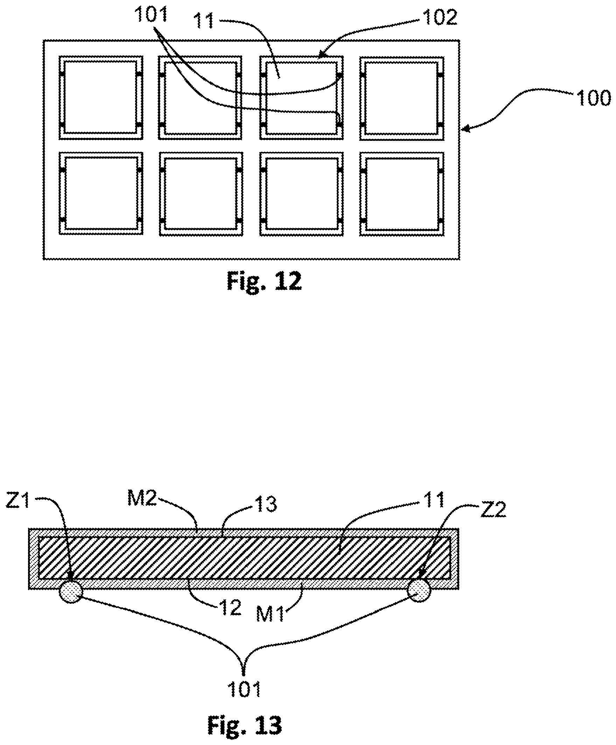

Sur le principe de la réalisation à deux fils 101 supportant la plaque 11, il est possible que le dispositif 100 de support puisse supporter plusieurs plaques 11 comme cela est représenté à titre d'exemples en figures 11 et 12. Selon un premier cas (figure 11) le dispositif 100 de support comporte le cadre 105 dont deux bords 105a, 105b sont reliés par deux fils 101 tendus pour supporter plusieurs plaques 11 simultanément. En figure 11, il est représenté à titre d'exemple deux rangées de plaques 11 (chaque rangée comportant quatre plaques 11 dans l'exemple illustré), les plaques 11 de chaque rangée de plaques 11 étant supportées seulement par des fils 11 (par exemple au nombre de deux) reliant, tout en étant tendus, les deux bords 105a, 105b. Selon ce premier cas, les plaques 11 sont supportées seulement par des fils 101 notamment à l'issue de l'exécution d'étapes c) permettant chacune de positionner une des plaques 11 via sa première face 12 en contact avec le dispositif 100 de support. Selon un deuxième cas, par exemple illustré en figure 12, le dispositif 100 de support comporte des emplacements 102 permettant chacun de recevoir une plaque 11, chaque emplacement 102 étant formé par une ouverture traversant le dispositif 100 de support, les ouvertures sont donc débouchantes. Selon ce deuxième cas, des étapes c) permettent chacune de positionner une des plaques 11 via sa première face 12 en contact avec le dispositif 100 de support. Chaque emplacement 102 peut être du type du logement décrit ci-avant. Chaque emplacement 102 comporte des fils 101 tendus, par exemple au nombre de deux. Par exemple, les fils tendus le sont entre deux bords opposés de l'ouverture correspondante de sorte que chaque plaque 11 puisse être positionnée, par l'étape c) correspondante, à l'emplacement 102 qui lui correspond de sorte à n'être en contact qu'avec des fils 101 à l'issue son positionnement.

La figure 13 permet d'illustrer à titre d'exemple un résultat des étapes d₁) et d₂) lorsque plusieurs fils 101 sont utilisés pour supporter la plaque 11 durant toute l'étape d₁) et durant toute l'étape d₂) : ces fils 101 forment alors des masques qui empêchent la formation du premier matériau M1 conducteur dans des zones Z1, Z2 de contact entre les fils 101 et la plaque 11. En choisissant des fils 101 adaptés, lorsque la plaque 11 est supportée seulement par ces fils 101, cela permet de limiter le masquage de la première face 12 de la plaque 11, notamment par rapport à la solution où la plaque 11 est en contact avec la portée 103 d'appui au cours de l'étape d₁). Ainsi, l'utilisation de fils 101 très fins, par exemple de diamètre compris entre 10 µm et 350 µm et préférablement de diamètre compris entre 20 µm et 100 µm, peut permettre le dépôt du premier matériau M1 conducteur sur quasiment toute la surface de la première face 12 de la plaque 11 hors des zones Z1 et Z2.

Même avec l'utilisation de fils 101 pour supporter la plaque 11, il existe un besoin d'encore améliorer le résultat de l'étape d₁) en cherchant à optimiser la formation du premier matériau M1 conducteur, par exemple en permettant que le premier matériau M1 conducteur recouvre toute la première face 12 de la plaque 11. En effet, si les fils 101 utilisés sont lisses, il est possible qu'au contact de chaque fil 101 et de la plaque 11 le dépôt du premier matériau M1 conducteur soit incomplet et/ou discontinu. Par exemple, pour un fil 101 de 40 µm de diamètre, il est possible qu'une zone masquée/ombrée de quelques microns sur la première face ne soit pas recouverte par le premier matériau M1 conducteur sur toute la longueur du contact entre le fil 101 et la plaque 11.

Dans le but d'éviter le masquage évoqué précédemment, plusieurs solutions techniques peuvent être envisagées :
- première solution : la ou les plaques 11 reposent sur plus de deux fils 101 au cours de l'étape d₁) en alternant les appuis de chaque plaque 11 sur des ensembles de fils différents ; par exemple, pour chaque plaque 11, le masquage obtenu lors de l'utilisation de deux premiers fils sur lesquels la première face 12 est en appui peut alors se retrouver recouvert lorsque les premiers fils sont à distance de la plaque 11 et qu'un support de la plaque 11 est assuré par deux deuxièmes fils alors en contact avec le premier matériau M1 conducteur déposé lors de l'appui de la première face 12 de la plaque 11 sur les premiers fils,
- deuxième solution : il est mis en oeuvre un déplacement de la ou des plaques 11 par rapport à la surface des fils supportant la ou les plaques 11 concernées (par exemple via un déplacement des fils, via un déplacement de la ou des plaques, via l'utilisation de vibrations mécaniques ou d'ultrasons).

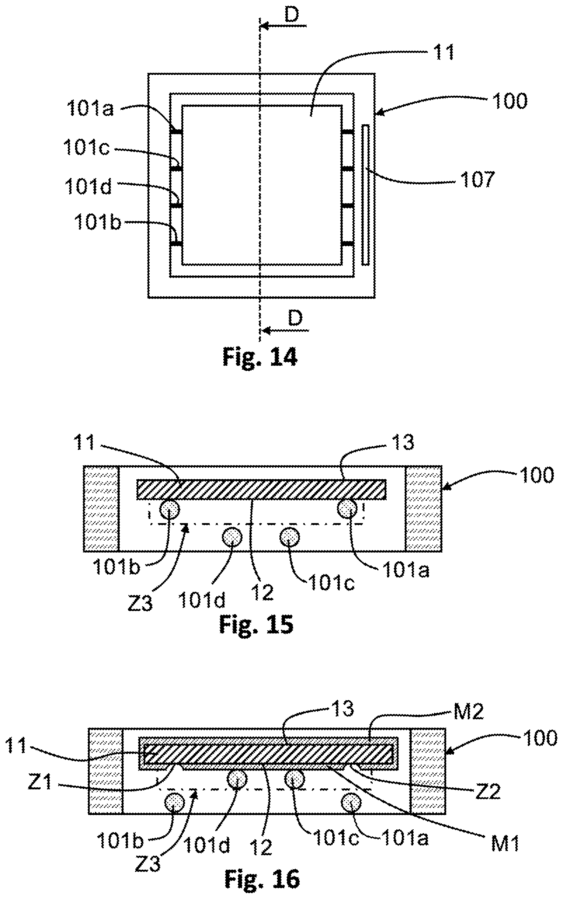

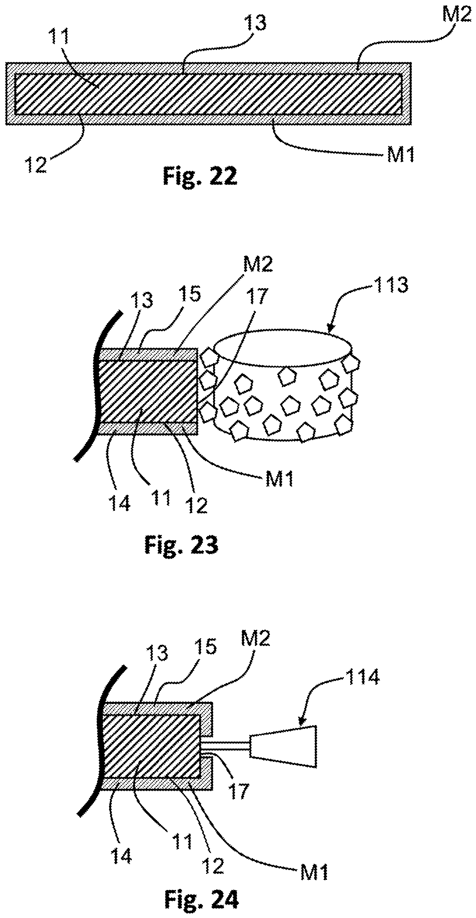

De manière générale, la première solution, dont un exemple de réalisation est illustré en figures 14 à 16, peut être mise en oeuvre de la manière suivante. Le dispositif 100 de support comporte un premier ensemble de fils et un deuxième ensemble de fils. L'étape d₁) comporte une première période et une deuxième période pendant lesquelles le premier matériau M1 conducteur est formé sur la première face 12 de la plaque 11. Pendant la première période, la première face 12 de la plaque 11 est en appui sur les fils 101a, 101b du premier ensemble de fils tandis que les fils 101c, 101d du deuxième ensemble de fils sont à distance de la plaque 11 (figure 15).
Pendant la deuxième période, la plaque 11 repose, par l'intermédiaire du premier matériau M1 conducteur formé sur sa première face 12 lors de la première période, sur les fils 101c, 101d du deuxième ensemble de fils tandis que les fils 101a, 101b du premier ensemble de fils sont à distance de la plaque 11 (figure 16).
Ceci présente l'avantage de permettre la formation du premier matériau M1 conducteur dans les zones Z1 et Z2 non couvertes par le premier matériau M1 conducteur à l'issue de la première période d'où il résulte l'obtention d'une plaque 11 dont la première face 12 est recouverte par le premier matériau M1 conducteur comme le montre par exemple la figure 22. Ceci permet, si les premier et deuxième matériaux M1, M2 sont identiques de former (étape d)) une unique couche de même matière de sorte à couvrir entièrement la plaque 11 comme le montre les figures 14 à 16 et 22.

En figures 15 et 16, il est représenté les fils 101a, 101b, 101c, 101d qui sont parallèles entre eux au cours de la première période et au cours de la deuxième période. Bien entendu, d'autres possibilités peuvent être envisagées, par exemple :
- les fils 101a, 101b du premier ensemble de fils peuvent être agencés de sorte à être en contact, au cours de la première période, avec des premier et deuxième coins de la plaque 11 opposés selon une diagonale de la plaque 11, et
- les fils 101c, 101d du deuxième ensemble de fils peuvent être agencés de sorte à soutenir la plaque 11 par l'intermédiaire de premier matériau M1 conducteur, au cours de la deuxième période, à des troisième et quatrième coins de la plaque 11 opposés selon une diagonale de la plaque 11, ces troisième et quatrième coins étant distincts des premier et deuxième coins.

Dans le cadre de la première solution et pour permettre sa mise en oeuvre efficace, les fils 101a, 101b, 101c, 101d étant répartis en un premier ensemble de fils et en un deuxième ensemble de fils, le dispositif 100 de support peut comporter un mécanisme 107 de positionnement (visible en figure 14) des fils 101 configuré pour varier entre une première configuration et une deuxième configuration. Dans la première configuration, les fils 101a, 101b du premier ensemble de fils sont positionnés dans une zone Z3 de support (figure 15). Dans la première configuration, les fils 101c, 101d du deuxième ensemble de fils sont à distance de la zone Z3 de support (figure 15). Dans la deuxième configuration, les fils 101c, 101d du deuxième ensemble de fils sont positionnés dans la zone Z3 de support (figure 16). Dans la deuxième configuration, les fils 101a, 101b du premier ensemble de fils sont à distance de la zone Z3 de support (figure 16). La zone Z3 de support est représentée en pointillé aux figures 15 et 16. Par exemple, le mécanisme 107 peut comporter des pièces excentriques montées à rotation et configurées chacune pour déplacer deux fils 101 agencés à des endroits différents sur la pièce excentrique, ceci permettrait alors, par rotation des pièces excentriques, de maintenir la plaque 11 à des endroits différents.

De manière générale, la deuxième solution peut être efficacement mise en oeuvre de la manière suivante : l'étape d₁) comporte, alors que les fils 101 supportent la plaque 11, un déplacement relatif entre la plaque 11 et les fils 101. Le déplacement relatif peut par exemple correspondre à déplacer la plaque en agissant sur la plaque 11 ou à déplacer les fils 101. Ce déplacement relatif peut être réalisé efficacement en transmettant, le cas échéant, à la plaque 11 ou aux fils 101 des vibrations mécanique, ou encore en soumettant la plaque 11 ou les fils 101 à une onde acoustique comme des ultrasons pour engendrer le déplacement relatif recherché. Autrement dit, le déplacement relatif peut être exécuté par utilisation de vibrations mécaniques ou acoustiques par exemple appliquées à la plaque 11 ou aux fils 101 supportant la plaque 11. En particulier les vibrations acoustiques sont ultrasoniques. Ainsi, un générateur 108 de vibrations (visible par exemple en figure 7), par exemple mécaniques ou acoustiques, peut être utilisé pour assurer le déplacement relatif. Un tel générateur 108 de vibrations peut être intégré au, ou être distinct du, dispositif 100 de support. Par exemple, le générateur 108 de vibrations peut comporter une source vibratoire couplée à une sonotrode sur laquelle repose le dispositif 100 de support pour permettre un déplacement de la ou des plaques au cours de l'étape d₁).

Les première et deuxième solutions, bien qu'idéales dans le sens où elles permettent de recouvrir complètement la première face 12 de la plaque 11, impliquent de mettre en oeuvre des déplacements de fils ou de plaques, ce qui peut être coûteux à mettre en oeuvre. En ce sens, il peut être avantageux de simplement limiter l'ombrage des fils 101 causé par le contact de ces fils 101 avec la première face 12 de la plaque 11. Une solution est que la ou les plaques 11 peuvent être en appui sur des fils 101 permettant la formation du premier matériau M1 conducteur sans ombrage continu. Pour cela, la ou les plaques 11 peuvent, par exemple, être en appui sur des fils 101 à grains 109 tels que des fils diamantés tout au long de l'étape d₁). Les fils diamantés peuvent comporter de l'ordre de cent diamants par millimètre. Dans ce cas, les fils 101 peuvent présenter une âme 110 de diamètre compris entre 20 µm et 100 µm et supportant des grains 109 dont la taille peut être comprise entre 10 µm et 20 µm ; ceci permettant de limiter l'ombrage lors de la mise en oeuvre de l'étape d₁). Des points de contact entre les fils 101 et les plaques 11 ne sont alors présents qu'aux endroits où il y a des grains 109. L'étape d₁) peut alors être réalisée en formant le premier matériau M1 conducteur à la surface de la première face 12 de la plaque 11 ou de chacune des plaques 11 sauf aux points de contact. Cette solution à fils 101 à grains 109 peut aussi s'appliquer lorsque le fil 101, par exemple lorsqu'il est unique, est en contact avec la plaque 11 comme par exemple dans le cadre de la réalisation des figures 5 et 6.

Ainsi, de manière générale, la solution à fils 101 comportant des grains 109 peut être mise en oeuvre par le fait que le ou chaque fil 101 du dispositif 100 de support, en contact avec la plaque 11 à l'issue de l'étape c), comporte une âme 110 et une pluralité de grains 109 fixés sur l'âme 110 (voir par exemple figure 17) par exemple comme cela est décrit ci-avant. À l'issue de l'étape c) et tout au long de l'étape d₁), la plaque 11 est en appui seulement sur des grains 109 par exemple du fil 101 ou de plusieurs fils 101. Ceci permet que pour la ou chaque plaque 11, lors de l'exécution de l'étape d₁), le premier matériau M1 conducteur va pouvoir se former sur la deuxième face 12 de la plaque 11 à l'exclusion des contacts ponctuels des grains 109 avec la deuxième face 12 de la plaque 11. Ainsi, dans ce cas le premier matériau M1 conducteur se dépose/se forme entre l'âme 110 du ou de chaque fils 101 et la deuxième face 12 de la plaque 11 supportée par le ou les fils 101. Il en résulte que les étapes d₁) et d₂) peuvent être exécutées de sorte à former une unique couche 16 de même matière couvrant en majorité la plaque 11 de sorte à délimiter localement la première couche 14 de premier matériau M1 conducteur et la deuxième couche 15 de deuxième matériau M2 conducteur (avec les premier et deuxième matériaux M1, M2 qui sont identiques et constitués par la matière).

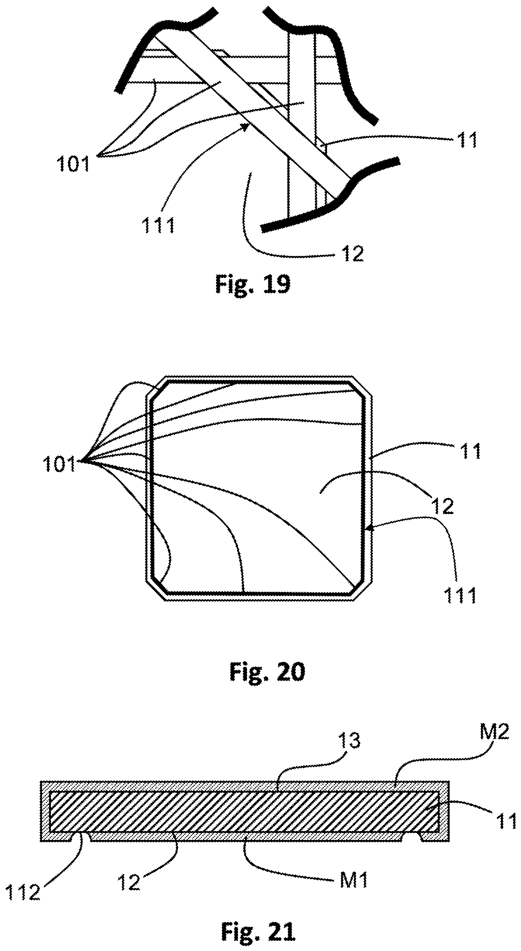

Dans certains cas, bien que l'on cherche à optimiser la surface de la deuxième face 12 couverte par le premier matériau M1 conducteur à l'issue de l'étape d₁), on cherche aussi à isoler, notamment électriquement, le premier matériau M1 conducteur déposé sur la première face 12 par rapport au deuxième matériau M2 conducteur déposé sur la deuxième face 13, par exemple pour former deux électrodes distinctes. Dès lors, pour permettre d'obtenir l'isolation recherchée directement au terme des étapes d₁) et d₂), il est possible d'utiliser un masque 111, dont des exemples sont illustrés en figures 18 à 20, s'opposant à la formation du premier matériau M1 conducteur sur une portion 112 (figure 21) de la première face 12 de la plaque 11.

De manière générale, pour former le masque 111 recherché dont l'avantage est de permettre de former/délimiter deux couches disjointes, le procédé de fabrication peut être tel qu'à l'issue de l'étape c), les fils 101 forment le masque 111 agencé contre la première face 12 de la plaque 11. Ce masque 111 empêche, lorsque l'étape d₁) est exécutée, la formation du premier matériau M1 conducteur sur la portion 112 (visible par exemple en figure 21) de la première face 12 de la plaque 11, ladite portion 112 s'étendant à la périphérie de la première face 12. Dans ce cas, il résulte de l'exécution des étapes d₁) et d₂) :
- la présence de la première couche 14 réalisée dans le premier matériau M1 conducteur et agencée sur la première face 12, et
- la présence de la deuxième couche 15 réalisée dans le deuxième matériau M2 conducteur et en contact avec la deuxième face 13 de la plaque 11,
les première et deuxième couches 14, 15 étant disjointes. Autrement dit, au terme de l'étape d₁), la portion 112 se présente sous la forme d'une boucle fermée. Cette boucle fermée est agencée le long de la périphérie de la première face 12 et cette boucle fermée est non-recouverte par le premier matériau M1 conducteur formé lors de l'étape d₁). Bien entendu, pour obtenir la portion 112 à la périphérie de la première face 12 de la plaque 11, le masque 111 reste en contact avec la première face 12 de la plaque 11 durant toute l'étape d₁) et notamment durant toute l'étape d₂).

Les fils 101 utilisés pour former le masque 111 peuvent être ici choisis de sorte que leur section, ou diamètre, soit adapté pour assurer la présence de la portion 112 non-recouverte par le premier matériau M1 conducteur à l'issue de l'étape d₁). Le diamètre des fils 101 peut dans ce cas être compris entre 180 µm et 350 µm. Dans ce cas, l'utilisation de fils lisses est recommandée de manière à assurer que la plaque 11 soit en contact avec les fil 101 pour permettre la présence de la portion 112.

Par exemple, les fils 101 formant le masque 111 sont maintenus tendus, en particulier par le cadre 105. Notamment, ces fils 101 sont tendus les uns au-dessus des autres et sont par exemple simplement en contact (c'est-à-dire sans liaison mécanique autre que des contacts) de sorte à former le masque 111. Sur la figure 18, les fils 101 sont au nombre de huit car la plaque 11 comporte des coins chanfreinés mais ce nombre peut être adapté en fonction de la forme de la plaque 11. La figure 19 illustre en particulier un coin de la plaque 11 pour montrer un exemple d'agencement des fils 11 à ce coin.

Par exemple, les fils 101 formant le masque 111 sont soudés comme le montre en particulier la figure 20 comportant huit fils 101 soudés. Ceci présente l'avantage de délimiter le masque 111 de sorte à ce que ce dernier forme un cadre plan sur lequel peut reposer la plaque 11, le masquage de la portion 112 de la deuxième face 12 est alors meilleur que dans le cadre de la figure 18 où du premier matériau M1 conducteur pourrait par exemple se déposer sur la plaque 11 à des endroits où se chevauchent les fils.

Selon que le masque 111 soit à fils simplement en contact entre eux ou soudés entre eux, la nature des fils 101 (c'est-à-dire leur composition), la rigidité des fils 101, la capacité des fils 101 à être soudés seront adaptées.

De manière générale, la position des fils 101, notamment avant l'étape c), peut être ajustée en fonction des dimensions de la plaque 11, ceci permettant au dispositif 100 de support de s'adapter et de ne pas être limité à un format de plaque 11 en particulier. Ceci peut s'appliquer du moment que la plaque 11 est supportée par plusieurs fils 101 et par exemple dans le cas de la présence du masque 111 lorsque les fils 101 ne sont pas soudés.

Il a été évoqué précédemment la possibilité d'utiliser le masque 111 pour obtenir et isoler les première et deuxième couches 14, 15 l'une par rapport à l'autre. Dans le cas où le masque 111 ne serait pas utilisé, il existe un besoin de trouver une solution pour obtenir une séparation électrique des première et deuxième couches 14, 15. Pour cela, le procédé de fabrication peut être tel qu'il résulte des étapes d₁) et d₂) la formation d'une matière à la surface de la plaque 11. Cette matière aussi appelée matière de recouvrement est peut être formée d'un unique matériau de sorte que les premier et deuxième matériaux M1, M2 conducteur peuvent par exemple être du TCO. Ainsi, le procédé de fabrication peut comporter une étape e) consistant à délimiter, dans la matière, la première couche 14 en contact avec la première face 12 de la plaque 11 et la deuxième couche 15 en contact de la deuxième face 13 de la plaque 11 de telle sorte que la première couche 14 est disjointe de la deuxième couche 15 (figures 23 et 24). Cette étape e) comporte une étape de retrait d'une portion de la matière. L'étape e) est préférentiellement mise en oeuvre lorsque les étapes d₁) et d₂) consistent en une étape d) de formation d'un même matériau conducteur transparent (c'est-à-dire la matière évoquée ci-avant) sur l'intégralité ou la majorité de la surface de la plaque 11 (figure 22).

L'étape de retrait peut être exécutée par une meule 113 ou un laser 114 comme le montrent par exemple respectivement les figures 23 et 24. La meule 113 et le laser 114 sont tout particulièrement adaptés chacun pour retirer la portion la matière afin de délimiter les première et deuxième couches 14, 15.

Le retrait de la portion de la matière est préférentiellement réalisé sur un bord 17 latéral de la plaque 11, le bord 17 latéral (par exemple visible en figures 2, 23, 24) reliant les première et deuxième faces 12, 13 de la plaque 11. Le bord 17 latéral peut présenter plusieurs côtés reliés entre eux dans le sens où il forme un contour latéral de la plaque 11. Ceci permet de conserver le recouvrement des première et deuxième faces 12, 13 de la plaque 11 par la matière afin de ne pas limiter le rendement effectif de la cellule 10 photovoltaïque.

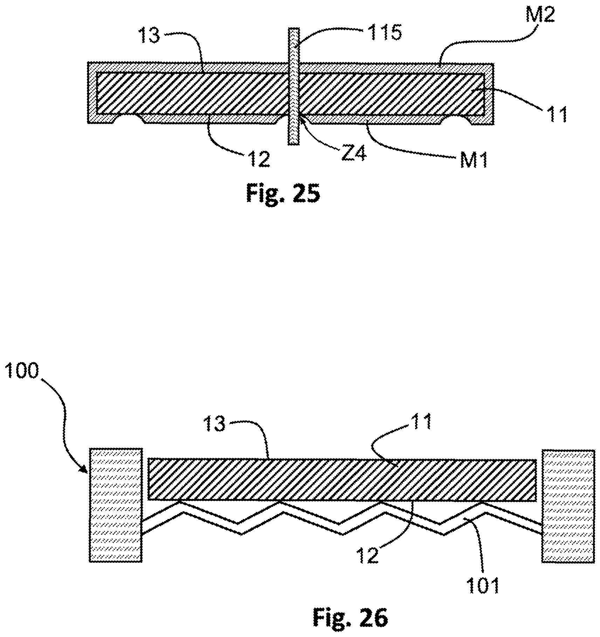

Il est possible que la plaque 11 soit, après l'étape d₁), découpée, par exemple pour former des cellules 10 photovoltaïques. Pour cela, l'étape c) peut positionner un élément de masquage, tel que le fil 101 ou un des fils 101 (figure 10), sur une zone Z4 de découpe formée par une partie de la surface de la première face 12. L'élément de masquage, appartenant au dispositif 100 de support, empêche la formation du premier matériau M1 conducteur sur la zone Z4 de découpe tout au long de l'étape d₁). Le procédé de fabrication peut ensuite comporter, par exemple comme illustré en figure 25, une étape de séparation de la plaque 11 en au moins deux parties, l'étape de séparation étant exécutée, après l'étape d₁) et notamment après l'étape d₂), par découpe au travers de la zone Z4 de découpe (en figure 25 il est représenté les premier et deuxième matériaux M1, M2 conducteurs notamment après l'étape d₁) et l'étape d₂) en ayant utilisé le dispositif 100 de support des figures 9 et 10). Ceci est préféré car cela permet par exemple d'éviter la diffusion d'espèce par exemple issue du premier matériau M1 conducteur dans la plaque 11, notamment cela permet d'éviter la diffusion d'espèce métallique dans le silicium de la plaque 11, et en particulier si la découpe se fait par voie thermique type découpe laser ou autre. La découpe peut aussi se faire par exemple à l'aide d'une scie 115.

Dans les réalisations où il a été évoqué l'utilisation d'un ou de plusieurs fils 101 à grains 109 tels que des fils diamantés, il peut être utilisé en alternative un fil 101 ou des fils 101 structurés comme cela est par exemple illustré en figure 26 qui montre en coupe le support de la plaque 11 par un dispositif 100 de support à fil(s) 101 structuré(s), c'est-à-dire présentant une forme de zigzag pour former des points locaux de support de la plaque 11 à la manière des grains 109 de sorte à autoriser la formation du premier matériau M1 conducteur lors de l'étape d₁) sur le plus possible de la surface de la première face 12 de la plaque 11 hors les points de contacts entre le ou les fils 101 et la plaque 11. Par exemple, la forme de zigzag est telle que le ou chaque fil 101 comportent une succession de segments, et que tout couple de segments consécutifs est tel que les segments de ce couple sont formés respectivement dans des plans sécants et notamment orthogonaux, ces plans étant aussi sécants au plan de la plaque 11 de sorte à former des points d'appuis locaux entre le fil 101 et la plaque 11 tout au long de l'étape d₁).

Bien entendu, pour accélérer les cadences de production des cellules 10 photovoltaïques, l'étape a) peut consister à prévoir plusieurs plaques 11, et pour chaque plaque 11 :
- l'étape c) est exécutée de sorte à positionner ladite plaque 11,
- l'étape d₁) est exécutée de sorte que le premier matériau M1 conducteur est déposé sur la première face 12 de ladite plaque 11 notamment alors supportée à l'aide d'au moins un fil 101 correspondant,
- l'étape d₂) est exécutée de sorte que le deuxième matériau M2 conducteur est déposé sur la deuxième face 13 de ladite plaque 11.
En particulier, le dépôt du premier matériau M1 conducteur et du deuxième matériau M2 conducteur peuvent être réalisés simultanément en déposant une même matière

La présente invention trouve une application industrielle dans la fabrication de cellules photovoltaïques à base de silicium ; et notamment les cellules photovoltaïque à base de silicium et à hétérojonction.

En particulier, lorsque les fils 101 sont utilisés pour supporter à eux seul la plaque 11, cela permet de réduire, voire supprimer selon les réalisations, la perte de rendement photovoltaïque de la cellule photovoltaïque dû à un masquage périphérique du dépôt de TCO provoqué par une surface d'appui d'un épaulement.

Idéalement, le dispositif 100 de support et/ou le ou les fils 101 peuvent présenter, au moins en surface, un matériau adapté, aussi appelé matériau neutre, pour éviter les problèmes de contamination de la plaque 11 lors de la formation des premier et deuxième matériaux M1, M2 conducteur. Par exemple, si le premier matériau M1 conducteur et le deuxième matériau M2 conducteur sont identiques, alors la surface du dispositif 100 de support peut être formée en premier matériau M1 conducteur elle aussi, comme par exemple de l'ITO.

## Revendications

1. Procédé de fabrication d'au moins une cellule (10) photovoltaïque, le procédé de fabrication comportant les étapes suivantes :
a) prévoir au moins une plaque (11), ladite plaque (11) comportant une première face (12) et une deuxième face (13) opposée à la première face (12),
b) prévoir un dispositif (100) de support,
c) positionner la plaque (11) en plaçant la première face (12) de la plaque (11) en contact avec le dispositif (100) de support,
d₁) former un premier matériau (M1) conducteur sur la première face (12) de la plaque (11) alors que la plaque (11) est supportée par le dispositif (100) de support,
d₂) former un deuxième matériau (M2) conducteur sur la deuxième face (13) de la plaque (11) alors que la plaque (11) est supportée par le dispositif (100) de support, **caractérisé en ce que** :
- au moins l'un des premier et deuxième matériaux (M1, M2) conducteurs est transparent,
- le dispositif (100) de support comporte au moins un fil (101), et
- durant tout ou partie de l'étape d₁), la première face (12) de la plaque (11) est en appui sur le fil (101).

2. Procédé de fabrication selon la revendication 1, **caractérisé en ce que** le dispositif (100) de support comporte un emplacement (102) pour la plaque (11), l'emplacement (102) comportant une portée (103) d'appui, et **en ce que**, à l'issue de l'étape c) et durant toute l'étape d₁), la première face (12) de la plaque (11) est en appui sur la portée (103) d'appui et sur le fil (101).

3. Procédé de fabrication selon la revendication 1, **caractérisé en ce que**, à l'issue de l'étape c), la première face (12) de la plaque (11) est en appui sur des fils (101) du dispositif (100) de support.

4. Procédé de fabrication selon la revendication 3, **caractérisé en ce que** :
- le dispositif (100) de support comporte un premier ensemble de fils et un deuxième ensemble de fils,
- l'étape d₁) comporte une première période et une deuxième période pendant lesquelles le premier matériau (M1) conducteur est formé sur la première face (12) de la plaque (11),
- pendant la première période, la première face (12) de la plaque (11) est en appui sur les fils (101a, 101b) du premier ensemble de fils tandis que les fils (101c, 101d) du deuxième ensemble de fils sont à distance de la plaque (11),
- pendant la deuxième période, la plaque (11) repose, par l'intermédiaire du premier matériau (M1) conducteur formé sur la première face (12) de la plaque (11) lors de la première période, sur les fils (101c, 101d) du deuxième ensemble de fils tandis que les fils (101a, 101b) du premier ensemble de fils sont à distance de la plaque (11).

5. Procédé de fabrication selon la revendication 3, **caractérisé en ce que** l'étape d₁) comporte, alors que les fils (101) supportent la plaque (11), un déplacement relatif entre la plaque (11) et les fils (101), par exemple exécuté par utilisation de vibrations mécaniques ou acoustiques.

6. Procédé de fabrication selon l'une quelconque des revendications 1 à 5, **caractérisé en ce que** :
- le fil (101) du dispositif (100) de support ou chaque fil (101) du dispositif (100) de support comporte une âme (110) et une pluralité de grains (109), les grains (109) de la pluralité de grains étant fixés sur l'âme (110), et
- à l'issue de l'étape c) et tout au long de l'étape d₁), la première face (12) de la plaque (11) est en appui seulement sur des grains (109).

7. Procédé de fabrication selon la revendication 3, **caractérisé en ce que** :
- à l'issue de l'étape c), les fils (101) forment un masque (111) agencé contre la première face (12) de la plaque (11),
- ledit masque (111) empêche, lorsque l'étape d₁) est exécutée, la formation du premier matériau (M1) conducteur sur une portion (112) de la première face (12) de la plaque (11), ladite portion (112) s'étendant à la périphérie de la première face (12) de la plaque (11), et
- il résulte de l'exécution de étape d₁) et de l'étape d₂), la présence d'une première couche (14) réalisée dans le premier matériau (M1) conducteur et agencée sur la première face (12) de la plaque (11), et la présence d'une deuxième couche (15) réalisée dans le deuxième matériau (M2) conducteur et en contact avec la deuxième face (13) de la plaque (11), les première et deuxième couches (14, 15) étant disjointes.

8. Procédé de fabrication selon l'une quelconque des revendications 3 à 7, **caractérisé en ce que**, avant l'étape c), la position des fils (101) est ajustée en fonction des dimensions de la plaque (11).

9. Procédé de fabrication selon l'une quelconque des revendications 1 à 8, **caractérisé en ce que** le premier matériau (M1) conducteur et le deuxième matériau (M2) conducteur sont chacun choisis parmi : un oxyde transparent conducteur et un matériau métallique.

10. Procédé de fabrication selon l'une quelconque des revendications 1 à 8, **caractérisé en ce qu'**il comporte une étape d) de formation d'une matière à la surface de la plaque (11), cette étape d) étant exécutée par la mise en oeuvre, par exemple simultanée, des étapes d₁) et d₂), le premier matériau (M1) conducteur et le deuxième matériau (M2) conducteur correspondant à un même oxyde transparent conducteur.

11. Procédé de fabrication selon l'une quelconque des revendications 1 à 6, **caractérisé en ce qu'**il résulte des étapes d₁) et d₂) la formation d'une matière à la surface de la plaque (11), et **en ce qu'**il comporte une étape e) consistant à délimiter, dans la matière, une première couche (14) en contact avec la première face (12) de la plaque (11) et une deuxième couche (15) en contact avec la deuxième face (13) de la plaque (11) de telle sorte que la première couche (14) est disjointe de la deuxième couche (15), l'étape e) comportant une étape de retrait d'une portion de la matière.

12. Procédé de fabrication selon la revendication 11, **caractérisé en ce que** l'étape de retrait est exécutée par une meule (113) ou un laser (114).

13. Procédé de fabrication selon l'une quelconque des revendications 11 à 12, **caractérisé en ce que** le retrait de la portion de la matière est réalisé sur un bord (17) latéral de la plaque (11), le bord latéral (17) reliant les première et deuxième faces (12, 13) de la plaque (11).

14. Procédé de fabrication selon l'une quelconque des revendications précédentes, **caractérisé en ce que** :
- l'étape c) positionne un élément de masquage appartenant au dispositif (100) de support sur une zone (Z4) de découpe formée par une partie de la surface de la première face (12), l'élément de masquage empêchant la formation du premier matériau (M1) conducteur sur la zone (Z4) de découpe tout au long de l'étape d₁), et
- il comporte une étape de séparation de la plaque (11) en au moins deux parties, l'étape de séparation étant exécutée, après l'étape d₁), par découpe au travers de la zone (Z4) de découpe.

15. Procédé de fabrication selon l'une quelconque des revendications précédentes, **caractérisé en ce que** l'étape a) consiste à prévoir plusieurs plaques (11) et **en ce que** pour chaque plaque (11) :
- l'étape c) est exécutée de sorte à positionner ladite plaque (11),
- l'étape d₁) est exécutée sorte que le premier matériau (M1) conducteur est déposé sur la première face (12) de ladite plaque (11),
- l'étape d₂) est exécutée de sorte que le deuxième matériau (M2) conducteur est déposé sur la deuxième face (13) de ladite plaque (11).

## Patentansprüche

1. Verfahren zur Herstellung mindestens einer Photovoltaikzelle (10), wobei das Herstellungsverfahren die folgenden Schritte umfasst:
a) Vorsehen mindestens einer Platte (11), wobei die Platte (11) eine erste Seite (12) und eine der ersten Seite (12) gegenüberliegende zweite Seite (13) umfasst,
b) Vorsehen einer Haltevorrichtung (100),
c) Positionieren der Platte (11) durch Inkontaktbringen der ersten Seite (12) der Platte (11) mit der Haltevorrichtung (100),
d₁) Bilden eines ersten leitfähigen Materials (M1) auf der ersten Seite (12) der Platte (11), während die Platte (11) von der Haltevorrichtung (100) gehalten wird,
d₂) Bilden eines zweiten leitfähigen Materials (M2) auf der zweiten Seite (13) der Platte (11), während die Platte (11) von der Haltevorrichtung (100) gehalten wird,
**dadurch gekennzeichnet, dass**:
- mindestens eines des ersten und des zweiten leitfähigen Materials (M1, M2) transparent ist,
- die Haltevorrichtung (100) mindestens einen Draht (101) umfasst, und
- während des gesamten oder eines Teils des Schritts d₁) die erste Seite (12) der Platte (11) auf dem Draht (101) aufliegt.

2. Herstellungsverfahren nach Anspruch 1, **dadurch gekennzeichnet, dass** die Haltevorrichtung (100) einen Platz (102) für die Platte (11) umfasst, wobei der Platz (102) eine Auflagefläche (103) umfasst, und dadurch, dass am Ende des Schritts c) und während des gesamten Schritts d₁) die erste Seite (12) der Platte (11) auf der Auflagefläche (103) und auf dem Draht (101) aufliegt.

3. Herstellungsverfahren nach Anspruch 1, **dadurch gekennzeichnet, dass** am Ende von Schritt c) die erste Seite (12) der Platte (11) auf Drähten (101) der Haltevorrichtung (100) aufliegt.

4. Herstellungsverfahren nach Anspruch 3, **dadurch gekennzeichnet, dass**:
- die Haltevorrichtung (100) einen ersten Satz Drähte und einen zweiten Satz Drähte umfasst,
- Schritt d₁) einen ersten Zeitraum und einen zweiten Zeitraum umfasst, während denen das erste leitfähige Material (M1) auf der ersten Seite (12) der Platte (11) gebildet wird,
- während des ersten Zeitraums die erste Seite (12) der Platte (11) auf den Drähten (101a, 101b) des ersten Satzes Drähte aufliegt, wohingegen sich die Drähte (101c, 101d) des zweiten Satzes Drähte in Abstand von der Platte (11) befinden,
- während des zweiten Zeitraums die Platte (11) mittels des ersten leitfähigen Materials (M1), das beim ersten Zeitraum auf der ersten Seite (12) der Platte (11) gebildet wurde, auf den Drähten (101c, 101d) des zweiten Satzes Drähte ruht, wohingegen sich die Drähte (101a, 101b) des ersten Satzes Drähte in Abstand von der Platte (11) befinden.

5. Herstellungsverfahren nach Anspruch 3, **dadurch gekennzeichnet, dass** Schritt d₁), während die Drähte (101) die Platte (11) halten, eine relative Verlagerung zwischen der Platte (11) und den Drähten (101) umfasst, die zum Beispiel durch Verwendung von mechanischen oder akustischen Schwingungen ausgeführt wird.

6. Herstellungsverfahren nach einem der Ansprüche 1 bis 5, **dadurch gekennzeichnet, dass**:
- der Draht (101) der Haltevorrichtung (100) oder jeder Draht (101) der Haltevorrichtung (100) einen Kern (110) und eine Vielzahl von Körnern (109) umfasst, wobei die Körner (109) der Vielzahl von Körnern auf dem Kern (110) befestigt sind, und
- am Ende von Schritt c) und während des gesamten Schritts d₁) die erste Seite (12) der Platte (11) nur auf Körnern (109) aufliegt.

7. Herstellungsverfahren nach Anspruch 3, **dadurch gekennzeichnet, dass**:
- am Ende von Schritt c) die Drähte (101) eine Maske (111) bilden, die an der ersten Seite (12) der Platte (11) angeordnet ist,
- die Maske (111), wenn Schritt d₁) ausgeführt wird, die Bildung des ersten leitfähigen Materials (M1) auf einem Abschnitt (112) der ersten Seite (12) der Platte (11) verhindert, wobei sich der Abschnitt (112) am Rand der ersten Seite (12) der Platte (11) erstreckt, und
- sich aus der Ausführung von Schritt d₁) und von Schritt d₂) das Vorhandensein einer ersten Schicht (14), die aus dem ersten leitfähigen Material (M1) hergestellt und auf der ersten Seite (12) der Platte (11) angeordnet ist, und das Vorhandensein einer zweiten Schicht (15) ergibt, die aus dem zweiten leitfähigen Material (M2) hergestellt ist und mit der zweiten Seite (13) der Platte (11) in Kontakt steht, wobei die erste und die zweite Schicht (14, 15) getrennt sind.

8. Herstellungsverfahren nach einem der Ansprüche 3 bis 7, **dadurch gekennzeichnet, dass** vor Schritt c) die Position der Drähte (101) in Abhängigkeit von den Abmessungen der Platte (11) angepasst wird.

9. Herstellungsverfahren nach einem der Ansprüche 1 bis 8, **dadurch gekennzeichnet, dass** das erste leitfähige Material (M1) und das zweite leitfähige Material (M2) jeweils ausgewählt sind aus: einem transparenten leitfähigen Oxid und einem metallischen Material.

10. Herstellungsverfahren nach einem der Ansprüche 1 bis 8, **dadurch gekennzeichnet, dass** es einen Schritt d) des Bildens eines Materials an der Oberfläche der Platte (11) umfasst, wobei dieser Schritt d) durch, zum Beispiel gleichzeitiges, Umsetzen der Schritte d₁) und d₂) ausgeführt wird, wobei das erste leitfähige Material (M1) und das zweite leitfähige Material (M2) demselben transparenten leitfähigen Oxid entsprechen.

11. Herstellungsverfahren nach einem der Ansprüche 1 bis 6, **dadurch gekennzeichnet, dass** sich aus den Schritten d₁) und d₂) die Bildung eines Materials an der Oberfläche der Platte (11) ergibt, und dadurch, dass es einen Schritt e) umfasst, der darin besteht, in dem Material eine erste Schicht (14) in Kontakt mit der ersten Seite (12) der Platte (11) und eine zweite Schicht (15) in Kontakt mit der zweiten Seite (13) der Platte (11) derart zu begrenzen, dass die erste Schicht (14) von der zweiten Schicht (15) getrennt ist, wobei Schritt e) einen Schritt des Entfernens eines Abschnitts des Materials umfasst.

12. Herstellungsverfahren nach Anspruch 11, **dadurch gekennzeichnet, dass** der Schritt des Entfernens mit einer Schleifscheibe (113) oder einem Laser (114) ausgeführt wird.

13. Herstellungsverfahren nach einem der Ansprüche 11 bis 12, **dadurch gekennzeichnet, dass** das Entfernen des Abschnitts des Materials an einer Seitenkante (17) der Platte (11) ausgeführt wird, wobei die Seitenkante (17) die erste und die zweite Seite (12, 13) der Platte (11) verbindet.

14. Herstellungsverfahren nach einem der vorstehenden Ansprüche, **dadurch gekennzeichnet, dass**:
- Schritt c) ein Maskenelement, das zur Haltevorrichtung (100) gehört, auf einer Schneidzone (Z4) positioniert, die von einem Teil der Oberfläche der ersten Seite (12) gebildet wird, wobei das Maskenelement während des gesamten Schritts d₁) die Bildung des ersten leitfähigen Materials (M1) auf der Schneidzone (Z4) verhindert, und
- es einen Schritt des Trennens der Platte (11) in mindestens zwei Teile umfasst, wobei der Schritt des Trennens nach Schritt d₁) durch Schneiden durch die Schneidzone (Z4) ausgeführt wird.

15. Herstellungsverfahren nach einem der vorstehenden Ansprüche, **dadurch gekennzeichnet, dass** Schritt a) darin besteht, mehrere Platten (11) vorzusehen, und dadurch, dass bei jeder Platte (11):
- Schritt c) ausgeführt wird, um die Platte (11) zu positionieren,
- Schritt d₁) ausgeführt wird, sodass das erste leitfähige Material (M1) auf der ersten Seite (12) der Platte (11) abgeschieden wird,
- Schritt d₂) ausgeführt wird, sodass das zweite leitfähige Material (M2) auf der zweiten Seite (13) der Platte (11) abgeschieden wird.

## Claims

1. A method for manufacturing at least one photovoltaic cell (10), the manufacturing method including the following steps:
a) providing at least one plate (11), said plate (11) including a first face (12) and a second face (13) opposite the first face (12),
b) providing a support device (100),
c) positioning the plate (11) by placing the first face (12) of the plate (11) in contact with the support device (100),
d₁) forming a first conductive material (M1) on the first face (12) of the plate (11) while the plate (11) is supported by the support device (100),
d₂) forming a second conductive material (M2) on the second face (13) of the plate (11) while the plate (11) is supported by the support device (100),
**characterized in that**:
- at least one of the first and second conductive materials (M1, M2) is transparent,
- the support device (100) includes at least one wire (101), and
- during all or part of step d₁), the first face (12) of the plate (11) bears on the wire (101).

2. The manufacturing method according to claim 1, **characterized in that** the support device (100) includes a slot (102) for the plate (11), the slot (102) including a bearing surface (103), and **in that**, at the end of step c) and throughout step d₁), the first face (12) of the plate (11) bears on the bearing surface (103) and on the wire (101).

3. The manufacturing method according to claim 1, **characterized in that**, at the end of step c), the first face (12) of the plate (11) bears on wires (101) of the support device (100).

4. The manufacturing method according to claim 3, **characterized in that**:
- the support device (100) includes a first set of wires and a second set of wires,
- step d₁) includes a first period and a second period during which the first conductive material (M1) is formed on the first face (12) of the plate (11),
- during the first period, the first face (12) of the plate (11) bears on the wires (101a, 101b) of the first set of wires while the wires (101c, 101d) of the second set of wires are spaced apart from the plate (11),
- during the second period, the plate (11) rests, through the first conductive material (M1) formed on the first face (12) of the plate (11) during the first period, on the wires (101c, 101d) of the second set of wires while the wires (101a, 101b) of the first set of wires are spaced apart from the plate (11).

5. The manufacturing method according to claim 3, **characterized in that** step d₁) includes, while the wires (101) support the plate (11), a relative displacement between the plate (11) and the wires (101), for example executed by using mechanical or acoustic vibrations.

6. The manufacturing method according to any one of claims 1 to 5, **characterized in that**:
- the wire (101) of the support device (100) or each wire (101) of the support device (100) includes a core (110) and a plurality of grains (109), the grains (109) of the plurality of grains being fastened on the core (110), and
- at the end of step c) and throughout step d₁), the first face (12) of the plate (11) bears only on grains (109).

7. The manufacturing method according to claim 3, **characterized in that**:
- at the end of step c), the wires (101) form a mask (111) arranged against the first face (12) of the plate (11),
- said mask (111) prevents, when step d₁) is executed, the formation of the first conductive material (M1) on a portion (112) of the first face (12) of the plate (11), said portion (112) extending to the periphery of the first face (12) of the plate (11), and
- it results from the execution of step d₁) and step d₂), the presence of a first layer (14) made from the first conductive material (M1) and arranged on the first face (12) of the plate (11), and the presence of a second layer (15) made from the second conductive material (M2) and in contact with the second face (13) of the plate (11), the first and second layers (14, 15) being separate.

8. The manufacturing method according to any one of claims 3 to 7, **characterized in that**, before step c), the position of the wires (101) is adjusted depending on the dimensions of the plate (11).

9. The manufacturing method according to any one of claims 1 to 8, **characterized in that** the first conductive material (M1) and the second conductive material (M2) are each chosen from: a transparent conductive oxide and a metallic material.

10. The manufacturing method according to any one of claims 1 to 8, **characterized in that** it includes a step d) of forming a material on the surface of the plate (11), this step d) being executed by the implementation, for example simultaneous, of steps d₁) and d₂), the first conductive material (M1) and the second conductive material (M2) corresponding to the same transparent conductive oxide.

11. The manufacturing method according to any one of claims 1 to 6, **characterized in that** it results from steps d₁) and d₂) the formation of a material on the surface of the plate (11), and **in that** it includes a step e) consisting in delimiting, in the material, a first layer (14) in contact with the first face (12) of the plate (11) and a second layer (15) in contact with the second face (13) of the plate (11) in such a way that the first layer (14) is separate from the second layer (15), step e) including a step of removing a portion of the material.

12. The manufacturing method according to claim 11, **characterized in that** the removal step is executed by a grinding wheel (113) or a laser (114).

13. The manufacturing method according to any one of claims 11 to 12, **characterized in that** the removal of the portion of the material is carried out on a lateral edge (17) of the plate (11), the lateral edge (17) connecting the first and second faces (12, 13) of the plate (11).

14. The manufacturing method according to any one of the preceding claims, **characterized in that**:
- step c) positions a masking element belonging to the support device (100) on a cutting area (Z4) formed by a part of the surface of the first face (12), the masking element preventing the formation of the first conductive material (M1) on the cutting area (Z4) throughout step d₁), and
- it includes a step of separating the plate (11) into at least two parts, the separation step being executed, after step d₁), by cutting through the cutting area (Z4).

15. The manufacturing method according to any one of the preceding claims, **characterized in that** step a) consists in providing several plates (11) and **in that** for each plate (11):
- step c) is executed so as to position said plate (11),
- step d₁) is executed so that the first conductive material (M1) is deposited on the first face (12) of said plate (11),
- step d₂) is executed so that the second conductive material (M2) is deposited on the second face (13) of said plate (11).
